# EUROPEAN PATENT APPLICATION

(11) **EP 4 808 294 A1**
(43) Date of publication of application: **16.09.2026**
(21) Application number: 24916278.5
(22) Date of filing: 22.05.2024
(51) Int. Cl.: H05K 5/02

(54) **HOUSING OF POWERTRAIN, POWERTRAIN, AND VEHICLE**

(30) Priority: 09.01.2024 CN 202410034674
(71) Applicant: Chery Automobile Co., Ltd., Wuhu, Anhui 241006 (CN)
(72) Inventor: SHU, Meizhen, Wuhu, Anhui 241006 (CN); YANG, Fuyong, Wuhu, Anhui 241006 (CN); YE, Yuanlong, Wuhu, Anhui 241006 (CN); YU, Song, Wuhu, Anhui 241006 (CN); WU, Qihao, Wuhu, Anhui 241006 (CN)
(74) Representative: Yang, Shu
(86) International application number: PCT/CN2024/094792
(87) International publication number: WO 2025/148222

(57) **Abstract**

The present application relates to the technical field of vehicles, and discloses a housing of a powertrain, a powertrain, and a vehicle. The housing comprises a shell and a sealing assembly. An accommodating cavity is formed in the interior of the shell, and the accommodating cavity is provided with a top wall and a bottom wall which are oppositely arranged. An operation opening is provided in the top wall, a wire harness mounting structure is provided on the bottom wall, and the wire harness mounting structure is used for fixing a high-voltage wire harness in the powertrain. The sealing assembly is detachably connected to the operation opening, and the sealing assembly is used for sealing or opening the accommodating cavity. According to the housing of the powertrain, the powertrain, and the vehicle provided by the present application, steps of assembling and disassembling the high-voltage wire harness in the powertrain are simplified.

## Description

This application claims priority to Chinese Patent Application No. 202410034674.7, filed on January 9, 2024, entitled "Shell and vehicle," the disclosure of which is herein incorporated by reference in its entirety.

### TECHNICAL FIELD

The present disclosure relates to the field of vehicle technologies, and more particularly to a housing for a powertrain, a powertrain, and a vehicle.

### BACKGROUND

Due to high-voltage operations, electric drive assemblies or hybrid drive assemblies necessitate the use of high-voltage wiring harnesses that are capable of handling large currents.

In the related arts, an assembly process for the high-voltage wiring harnesses is relatively complicated, and a large number of assembly members are employed, resulting in increased manufacturing costs.

### SUMMARY

In view of the above, the present disclosure provides a housing for a powertrain, a powertrain, and a vehicle.

Specifically, embodiments of the present disclosure provide the following technical solutions:
According to a first aspect, a housing for a powertrain is provided. The housing for the powertrain includes a housing body and a sealing assembly; wherein
an accommodating cavity is defined in the housing body, the accommodating cavity having a top wall and a bottom wall that are opposite to each other, wherein an operation opening is defined in the top wall, and a wiring harness mounting structure is disposed on the bottom wall, the wiring harness mounting structure being configured to secure a high-voltage wiring harness in the powertrain; and
the sealing assembly is detachably connected to the operation opening and configured to seal or open the accommodating cavity.

In some embodiments, an opening area of the operation opening is smaller than an area of the top wall of the accommodating cavity.

In some embodiments, an orthographic projection of the wiring harness mounting structure on the bottom wall is within an orthographic projection of the operation opening on the bottom wall.

In some embodiments, a center of the operation opening is located on a centerline of a designated surface, wherein the designated surface is a surface configured to be connected to a tool and achieve assembly and disassembly in operation surfaces of the wiring harness mounting structure.

In some embodiments, the sealing assembly includes a connecting member, wherein a mounting groove is defined in the connecting member, an opening of the mounting groove facing the bottom wall; and
the housing body includes a protruding portion, wherein the protruding portion is connected to a side, away from the bottom wall, of the top wall and surrounds the operation opening, and the protruding portion is disposed within the mounting groove and hermetically connected to the mounting groove.

In some embodiments, the connecting member includes a body portion, a connecting portion, and an extension portion that are sequentially connected;
wherein the body portion is positioned at an inner side of the protruding portion and extends into the operation opening, and the body portion is detachably connected to the top wall;
the connecting portion is connected to an end, away from the bottom wall, of the body portion and rests on an end, away from the top wall, of the protruding portion; and
the extension portion is connected to an end, away from the body portion, of the connecting portion and extends toward the bottom wall, the extension portion and the body portion are spaced apart, and the body portion, the connecting portion, and the extension portion collaboratively define the mounting groove.

In some embodiments, a groove is defined in a surface, facing the body portion, of the extension portion; and
the sealing assembly includes a first sealing member, wherein the first sealing member is received in the groove and separately abuts against a groove bottom wall of the groove and an outer wall of the protruding portion, the groove bottom wall being opposite to the outer wall of the protruding portion.

In some embodiments, the first sealing member is a sealing ring, and a width of the groove (2141) is less than or equal to an outer diameter of the sealing ring.

In some embodiments, the groove is defined in a surface, close to the body portion, of the extension portion and positioned in a middle region of the extension portion.

In some embodiments, the groove extends to an edge, away from the connecting portion, of the extension portion to cause a side, away from the connecting portion, of the groove to open; and
the sealing assembly further includes a blocking member, wherein the blocking member is snap-fit with the connecting member, and at least a portion of the blocking member is disposed on a side, close to the bottom wall, of the extension portion to close the side, away from the connecting portion, of the groove.

In some embodiments, a plurality of snap-fit structures are defined on a surface, away from the body portion, of the extension portion, the plurality of snap-fit structures being spaced apart; and
the blocking member includes a connecting ring and a plurality of connecting hooks, wherein the plurality of connecting hooks are connected to the connecting ring and circumferentially spaced apart along the connecting ring, and the plurality of connecting hooks are configured to respectively snap-fit with corresponding snap-fit structures.

In some embodiments, an axial length of the connecting ring is less than a radial length of the connecting ring, the connecting ring is configured to block the side, away from the connecting portion, of the groove, and the plurality of connecting hooks are perpendicularly connected to an outer side wall of the connecting ring, the radial length is a distance between the outer side wall and an inner side wall of the connecting ring.

In some embodiments, an inclined surface is defined on a side, away from the bottom wall, of an outer wall of the protruding portion, wherein the inclined surface is gradually close to an inner wall of the protruding portion as extending away from the bottom wall, and the inner wall of the protruding portion is opposite to the outer wall of the protruding portion.

According to a second aspect of the present disclosure, a powertrain is provided, wherein the powertrain includes the housing for the powertrain described above.

According to a third aspect of the present disclosure, a vehicle is provided, wherein the vehicle includes the housing for the powertrain described above, or includes the powertrain described above.

### BRIEF DESCRIPTION OF DRAWINGS

For a clearer description of the technical solutions according to the embodiments of the present disclosure, the following briefly describes the accompanying drawings required for describing the embodiments. Apparently, the accompanying drawings in the following description show merely some embodiments of the present disclosure, and those of ordinary skill in the art may still derive other drawings from these accompanying drawings without creative efforts.
FIG. 1 is a cross-sectional view of the housing for the powertrain according to some embodiments of the present disclosure;
FIG. 2 is a first structural schematic diagram of the housing for the powertrain according to some embodiments of the present disclosure;
FIG. 3 is a second structural schematic diagram of the housing for the powertrain according to some embodiments of the present disclosure;
FIG. 4 is a cross-sectional view of another housing for the powertrain according to some embodiments of the present disclosure;
FIG. 5 is a partial cross-sectional view of the housing for the powertrain according to some embodiments of the present disclosure;
FIG. 6 is a partially enlarged view of the housing for the powertrain according to some embodiments of the present disclosure;
FIG. 7 is a cross-sectional view of a connecting member according to some embodiments of the present disclosure;
FIG. 8 is an exploded view of a sealing assembly according to some embodiments of the present disclosure;
FIG. 9 is a structural schematic diagram of a blocking member according to some embodiments of the present disclosure; and
FIG. 10 is a structural schematic diagram of a connecting member according to some embodiments of the present disclosure.

### DETAILED DESCRIPTION

The technical solutions according to the embodiments of the present disclosure are clearly and completely described hereinafter in conjunction with the accompanying drawings of the embodiments of the present disclosure. Apparently, the described embodiments are merely some embodiments of the present disclosure rather than all embodiments. Any other embodiments acquired based on the embodiments of the present disclosure by a person skilled in the art without making creative efforts all fall within the protection scope of the present disclosure.

It should be noted that the housing provided by the embodiments of the present disclosure can be applied to an electric drive assembly or a hybrid drive assembly. In the case that the housing is applied to an electric drive assembly, the housing is an electric drive housing; and in the case that the housing is applied to a hybrid drive assembly, the housing is a hybrid drive housing. In the following solutions, the present disclosure is adaptively illustrated by taking the case where the housing is an electric drive housing as an example.

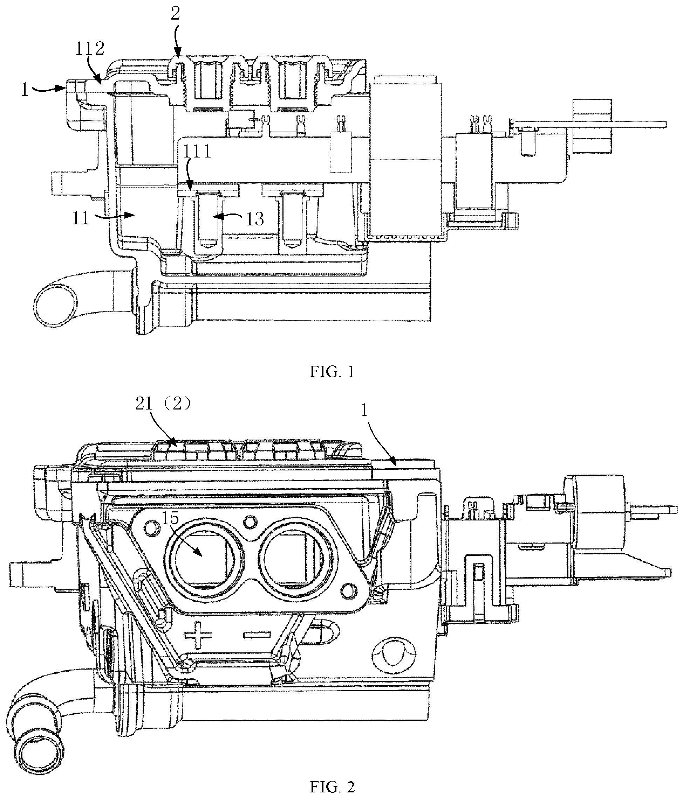

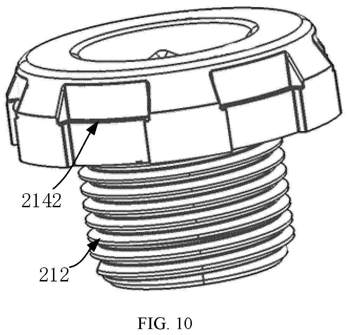

To clearly describe the technical solutions and advantages of the present disclosure, the housing for the powertrain, the powertrain, and the vehicle are illustrated in detail in conjunction with FIGS. 1 to 10.

In the related art, the housing for the electric drive system generally consists of a bottom shell and a high-voltage cover plate that are separately provided. An EMC (Electromagnetic Compatibility) component is disposed in the bottom shell, the high-voltage wiring harness extents into the bottom shell and is connected to the EMC component, the high-voltage cover plate is connected to the bottom shell through a plurality of connecting members (such as screws), and then a loop of sealant is provided on the high-voltage cover plate to achieve the seal between the high-voltage and the bottom shell.

However, in this configuration, during the assembly of the entire vehicle, the high-voltage cover plate needs to be taken down, then the high-voltage wiring harness is mounted, and subsequently, the high-voltage cover plate is re-connected to the bottom shell and sealed again. The assembly process is complicated, and a large number of connecting members need to be used to achieve the connection, leading to an increased manufacturing cost. Further, the sealant makes the disassembly between the high-voltage cover plate and the bottom shell difficult, thereby increasing the assembly difficulty of the vehicle.

In view of the above, the embodiments of the present disclosure provide a housing for a powertrain. As shown in FIGS. 1 and 2, the housing includes a housing body 1 and a sealing assembly 2. An accommodating cavity 11 is defined in the housing body 1, and the accommodating cavity 11 has a top wall 112 and a bottom wall 111 that are opposite to each other. An operation opening 12 is defined in the top wall 112, and a wiring harness mounting structure 13 is disposed on the bottom wall 111. The wiring harness mounting structure 13 is configured to secure the high-voltage wiring harness in the powertrain. The sealing assembly 2 is detachably connected to the operation opening 12 and configured to seal or open the accommodating cavity 11.

In the housing for the powertrain provided by the embodiments of the present disclosure, an accommodating cavity 11 is formed in the housing body 1, and a wiring harness mounting structure 13 is disposed on the bottom wall 111 of the accommodating cavity 11. The high-voltage wiring harness is connected to the EMC component and fixed in the accommodating cavity 11 via the wiring harness mounting structure 13. Because an operation opening 12 is defined in the top wall 112 of the housing body 1, in the case that it is necessary to assemble or disassemble the high-voltage wiring harness, the high-voltage wiring harness is fixed or disassembled by just taking down the sealing assembly 2 and then operating the high-voltage wiring harness through the operation opening 12. Subsequently, the sealing assembly 2 is remounted to achieve sealing, thereby completing the assembly or disassembly process of the high-voltage wiring harness. Compared to the split-type electric drive housing with an independent cover plate in the related art, the assembly and disassembly process of the electric drive housing provided by the embodiments of the present disclosure is relatively simple, the number of connecting members is reduced, and the seal method is simple and reliable.

Additionally, because the sealing assembly 2 provided in the embodiments of the present disclosure is detachably connected to the operation opening 12, operators can open or seal the operation opening 12 as needed. Therefore, relative to the sealing method using sealant in the related art, the sealing method of the present disclosure is more convenient, and the assembly and disassembly are more convenient.

It should be understood that the accommodating cavity 11 of the housing body 1 is configured to receive the EMC component, and the high-voltage wiring harness is connected to the EMC component and fixed in the accommodating cavity 11 via the wiring harness mounting structure 13.

In some embodiments, the wiring harness mounting structure 13 is a bolt, a snap-fit member, or other connecting members capable of achieving a fixing function. Those skilled in the art are able to select and adjust the type of the wiring harness mounting structure 13 according to actual needs. In some embodiments, the wiring harness mounting structure 13 is a fixing bolt. A threaded hole is defined in the bottom wall 111 of the accommodating cavity 11. The high-voltage wiring harness is positioned between the nut of the fixing bolt and the bottom wall 111 of the accommodating cavity 11. The high-voltage wiring harness is secured by connecting the fixing bolt to the threaded hole.

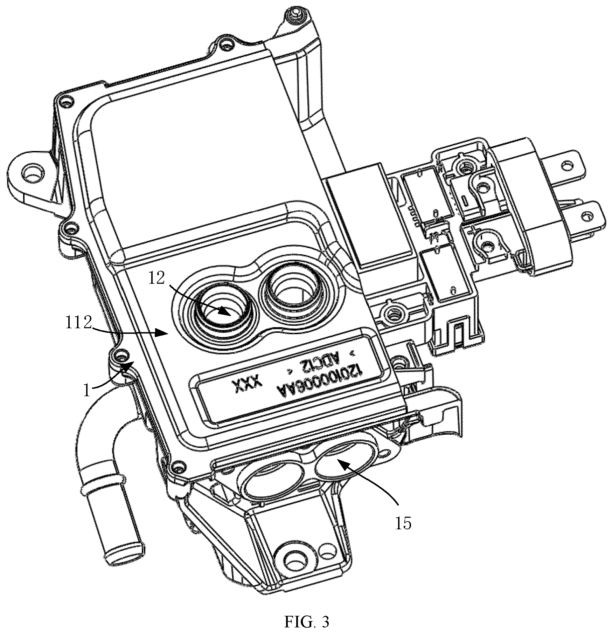

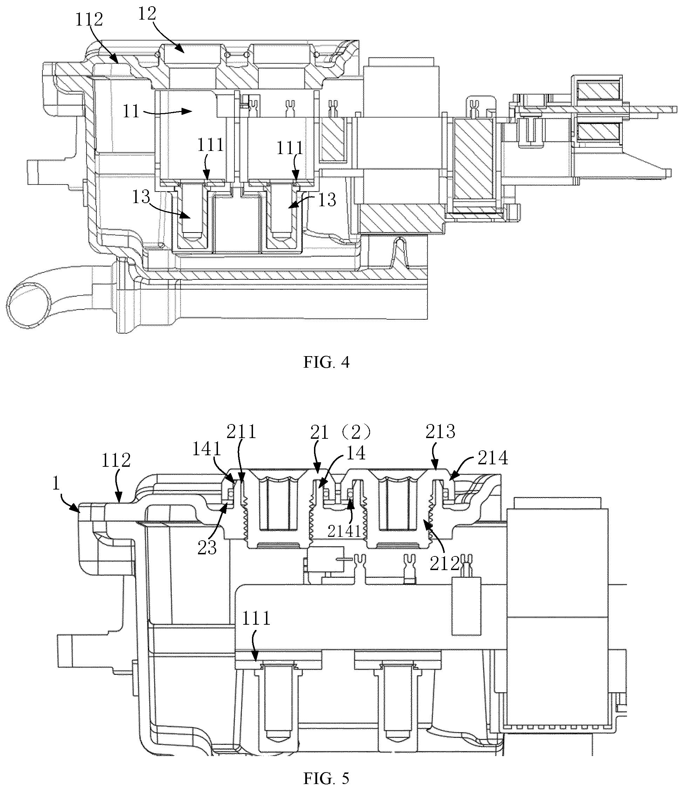

In some embodiments of the present disclosure, as shown in FIGS. 3 and 4, an opening area of the operation opening 12 is smaller than an area of the top wall 112 of the accommodating cavity 11, i.e., the housing body 1 is a one-piece structure, and the top wall 112 of the accommodating cavity 11 is equivalent to the high-voltage cover plate in the related art. The operation opening 12 is located in the top wall 112, and therefore, in the case that it is necessary to assemble or disassemble the high-voltage wiring harness, the high-voltage wiring harness is fixed or disassembled by just operating the high-voltage wiring harness via the operation opening 12 on the top wall 112 of the accommodating cavity 11. Compared to the split-type electric drive housing in the related art, the above simplifies the assembly or disassembly process and reduces the number of connecting members.

It should be noted that the operation opening 12 is a through opening formed on the top wall 112, and the top wall 112 includes the operation opening 12 and other portions besides the operation opening 12.

In some embodiments of the present disclosure, as shown in FIG. 3, an orthographic projection of the wiring harness mounting structure 13 on the bottom wall 111 is within an orthographic projection of the operation opening 12 on the bottom wall 111, i.e., the operation opening 12 is squarely opposite to the wire harness mounting structure 13, which provides a bigger operation space for tools, allowing operators to conveniently fix or disassemble the high-voltage wiring harness by using a tool to operate the wiring harness mounting structure, such as tightening or loosening the above fixing screw. In other words, by disposing the operational opening 12 in the embodiments of the present disclosure, a convenient and easy-to-operate space is provided to achieve the disassembly of the high-voltage wiring harnesses.

Furthermore, the large-area operation opening has better adaptability, allows operators to use tools of different sizes or types to assemble or disassemble the wiring harness mounting structure 13, provides a larger motion space during operation, and makes the operation more convenient.

Additionally, to achieve more precise and convenient assembly or disassembly of the high-voltage wiring harness, in some embodiments, a center of the operation opening 12 is located on a centerline of a surface configured to be connected to a tool and achieve assembly and disassembly in operation surfaces of the wiring harness mounting structure 13. That is, the wiring harness mounting structure 13 is positioned directly below the operational opening 12, enabling tools to contact the wiring harness mounting structure 13 vertically without additional rotation or tilting, thereby simplifying the operation process of operators or machines and reducing the operation difficulty. Additionally, operating directly above the wiring harness mounting structure 13 minimizes errors caused by misalignment between axes of the tool and the wiring harness mounting structure 13. Especially in the case that the wiring harness mounting structure 13 is a fixing bolt, the control for the tool to tighten or loosen the fixing bolt is improved by making the axes of the tool and the bolt overlap with each other, and problems such as poor fixation caused by inaccurate operation are reduced.

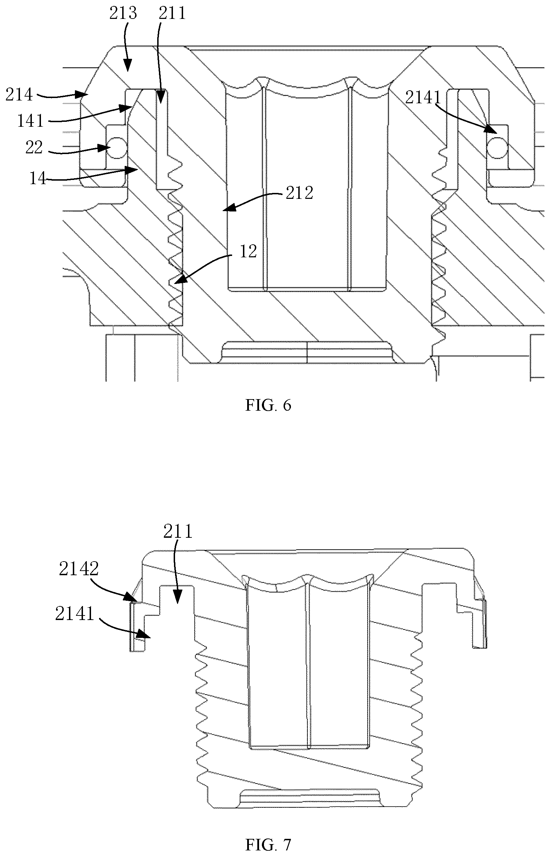

In some embodiments of the present disclosure, as shown in FIGS. 5 and 6, the sealing assembly 2 includes a connecting member 21, wherein a mounting groove 211 is defined in the connecting member 21, an opening of the mounting groove 211 facing the bottom wall 111; and the housing body 1 includes a protruding portion 14, wherein the protruding portion 14 is connected to a side, away from the bottom wall 111, of the top wall 112 and surrounds the operation opening 12, and the protruding portion 14 is disposed within the mounting groove 211 and hermetically connected to the mounting groove 211.

In some embodiments, the protruding portion 14 is a ring-shaped protrusion that is raised on the outer surface of the housing body 1 and has a certain height, with the operation opening 12 located on the inner side of the ring-shaped protrusion. It should be noted that insulating materials in high-voltage wiring harnesses, such as insulating leather or insulating sleeves, are possible to become damaged or degraded in the case of being exposed to a humid environment or subjected to external factors such as dust. Additionally, a humid environment possibly causes water to enter the high-voltage wiring harness, and because water is an electrical conductor, the insulation performance of the high-voltage wiring harness is possibly decreased, or even a short circuit or electric leakage possibly occurs.

Therefore, in the housing for the powertrain provided by the embodiments of the present disclosure, the protruding portion 14 are disposed on the housing body 1, the mounting groove 211 is defined in the connecting member 21, and the protruding portion 14 and the mounting groove 211 cooperate with each other, i.e., the protruding portion 14 is mounted in the groove 2141, so as to prevent liquid, gas, or other medium from entering the operation opening 12 via the outer surface of the housing body 1 with the help of the height of the protrusion 14 on the outer surface of the housing body 1. In this way, a good seal effect is achieved, and the insulation performance of the high-voltage wiring harness is prevented from being affected by the liquid or gas.

Furthermore, during the assembly process, the design of the protruding portion 14 and the mounting groove 211 enables the connecting member 21 to automatically center and align itself, thereby simplifying the assembly and disassembly of the connecting member 21 and ensuring a good sealing effect during assembly.

In some embodiments, the connecting member 21 is a screw plug, the side walls of the housing body 1 forming the operation opening 12 are machined with internal threads, and the connecting member 21 and the operation opening 12 are connected by threaded connection. Correspondingly, the protruding portion 14 is shaped as a circular ring.

In some embodiments of the present disclosure, as shown in FIGS. 5 and 6, the connecting member 21 include a body portion 212, a connecting portion 213, and an extension portion 214 that are sequentially connected; wherein the body portion 212 is positioned at an inner side of the protruding portion 14 and extends into the operation opening 12, and the body portion 212 is detachably connected to the top wall 112; the connecting portion 213 is connected to an end, away from the bottom wall 111, of the body portion 212 and rests on an end, away from the top wall 112, of the protruding portion 14; and the extension portion 214 is connected to an end, away from the body portion 212, of the connecting portion 213 and extends toward the bottom wall 111, the extension portion 214 and the body portion 212 are spaced apart, and the body portion 212, the connecting portion 213, and the extension portion 214 collaboratively define the mounting groove 211.

In the housing for the powertrain provided by the embodiments of the present disclosure, the extension direction of the extension portion 214 is parallel to the axial direction of the body portion 212, and the extension portion 214 is spaced apart from the outer wall of the body portion 212. The body portion 212, the connecting portion 213, and the extension portion 214 collaboratively define a mounting groove 211 with a U-shaped cross-section. The mounting groove 211 is configured to cooperate with the protruding portion 14 to achieve sealing for the operation opening 12.

During the assembly process, the connecting member 21 is capable of automatically aligning itself based on the design of the protruding portion 14 and the mounting groove 211, making the assembly and disassembly processes relatively simple.

In some embodiments, a second sealing member (not shown in the figures) is disposed between the connecting portion 213 and the protruding portion 14, and/or between the extension portion 214 and the protruding portion 14. The second sealing member is configured to further enhance the sealing effect between the connecting member 21 and the protruding portion 14 and effectively isolate the external environment from the accommodating cavity 11.

The specific type of the second sealing member is selected according to actual needs, such as sealing rings or gaskets made of silicone or rubber, or seal products such as a raw material belt or sealing gel that remains in a paste-like state under application conditions.

It should be noted that, to facilitate understanding, the present disclosure is illustrated by dividing the connecting member 21 into three portions: the body portion 212, the connecting portion 213, and the extension portion 214. In practice, in some embodiments, the connecting member 21, including the body portion 212, the connecting portion 213, and the extension portion 214, is a one-piece structure.

In the above embodiments, the connecting member 21 achieves preliminary sealing for the operation opening 12 through the cooperation of the mounting groove 211with the protruding portion 14. To enhance the sealing performance of the sealing assembly 2, in some embodiments of the present disclosure, as shown in FIG. 3, a groove 2141 is defined in a surface, facing the body portion 212, of the extension portion 214; and the sealing assembly 2 includes a first sealing member 22, wherein the first sealing member 22 is received in the groove 2141 and separately abuts against a groove bottom wall 111 of the groove 2141 and an outer wall of the protruding portion 14, the groove bottom wall 111 being opposite to the outer wall of the protruding portion 14.

By disposing the first sealing member 22 in the groove 2141, in the case that the connecting member 21 is engaged with the protruding portion 14, the first sealing member 22 clamps the outer wall of the protruding portion 14, thereby forming an additional seal. Therefore, the cooperation of the connecting member 21 and the first sealing member 22 with the protruding portion 14 achieves a dual-seal for the operation opening 12, thereby enhancing the overall sealing performance of the sealing assembly 2, further preventing liquids, gases, or other medium from entering the operation opening 12 and the interior of the accommodating cavity 11, and ensuring the insulation performance of the high-voltage wiring harness.

In some embodiments, the first sealing member 22 is a sealing ring, and a width of the groove 2141 is less than or equal to an outer diameter of the sealing ring. In this way, the sealing ring is positioned in the groove 2141 under its own elastic force without easily falling under an external force, facilitating assembly of the sealing assembly 2 with the protruding portion 14 by the operator.

In some embodiments, the assembly sequence of the connecting member 21, the first sealing member 22, and the housing body 1 is as follows: first, the first sealing member 22 is crammed into the groove 2141 on the connecting member 21, at which time the first sealing member 22 is retained within the groove 2141 due to its own elasticity and is unlikely to fall out; then the connecting member 21 on which the first sealing member 22 is mounted is assembled onto the protruding portion 14, wherein the body portion 212 of the connecting member 21 extends into the operation opening 12, the protruding portion 14 engages into the mounting groove 211 of the connecting member 21, and the first sealing member 22 securely clamps onto the outer wall of the protruding portion 14, and the two sides of the first sealing member 22 elastically contact the protruding portion 14 and the groove bottom wall 111 of the groove 2141, as shown in FIG. 3; and finally, the connecting member 21 is rotated to enable the connecting member 21 to be connected to the housing body 1 via the external threads on the body portion 212, thereby completing the assembly of the sealing assembly 2 with the housing body 1.

In some embodiments, the groove 2141 is defined in a surface, close to the body portion 212, of the extension portion 214 and positioned in a middle region of the extension portion 214. To form this structure, the groove 2141 needs to be machined directly on the surface, close to the body portion 212, of the extension portion 214, and the machining equipment needs to be inserted into the mounting groove 211 to machine the extension portion 214, which not only increases the machining difficulty but also puts forward higher requirements on the machining equipment.

It should be noted that the aforementioned middle region refers to a region on the extension portion that is spaced apart from the outer edge of the extension portion.

Therefore, to reduce processing difficulty, in some embodiments of the present disclosure, the groove 2141 extends to an edge, away from the connecting portion 213, of the extension portion 214 to cause a side, away from the connecting portion 213, of the groove 2141 to open; and the sealing assembly 2 further includes a blocking member 23, wherein the blocking member 23 is snap-fit with the connecting member 21, and at least a portion of the blocking member 23 is disposed on a side, close to the bottom wall 111, of the extension portion 214 to close the side, away from the connecting portion 213, of the groove 2141.

It is easy to understand that one side of the groove 2141 itself is open, with the opening direction of this side facing the body portion 212; and in the case that the side, away from the connecting portion 213, of the groove 2141 (referred to as a first side) extends to the edge, away from the connecting portion 213, of the extension portion 214, the first side of the groove 2141 actually becomes open with an opening direction facing the bottom wall 111 of the accommodating cavity 11. In other words, as shown in FIG. 3, the groove 2141 is now open at two adjacent sides.

As shown in FIG. 7, the first side of the groove 2141 is set to be open, and the connecting member 21 further cooperates with a blocking member 23 to retain the first sealing member 22. Compared to the aforementioned method of machining a groove in the middle region of the extension portion 214, this groove configuration involves machining a stepped structure at the end, close to the bottom wall 111, of the extension portion 214 by milling or other machining methods. This makes the machining process more convenient and suitable for mass production requirements. Subsequently, the first sealing member 22 is retained by connecting the blocking member 23 to the first side of the stepped structure to enable the blocking member 23 to block the first side.

In some embodiments, the assembly sequence of the connecting member 21, the first sealing member 22, the blocking member 23, and the housing body 1 is as follows: first, the connecting member 21 is connected to the blocking member 23 to form a groove for accommodating the first sealing member 22 on the inner side of the outer extension; then, the first sealing member 22 is inserted into the groove 2141 on the connecting member 21, at which time the first sealing member 22 is retained in the groove 2141 due to its own elasticity and unlikely to fall out; and then, the connecting member 21 equipped with the first sealing member 22 is assembled onto the protruding portion 14.

The body portion 212 of the connecting member 21 extends into the operation opening 12, the protruding portion 14 is engaged with the mounting groove 211 of the connecting member 21, and the first sealing member 22 clamps onto the outer wall of the protruding portion 14. The two sides of the first sealing member 22 elastically abut against the protruding portion 14 and the groove bottom wall 111 of the groove 2141, respectively, as shown in FIG. 3. Finally, the connecting member 21 is rotated to enable the connecting member 21 to be connected to the housing body 1 via the external threads on the body portion 212, thereby completing the assembly of the sealing assembly 2 with the housing body 1.

In the embodiments of the present disclosure, the blocking member 23 is connected to the connecting member 21 by any means, such as snap-fitting, screw connection, interference fit, etc.

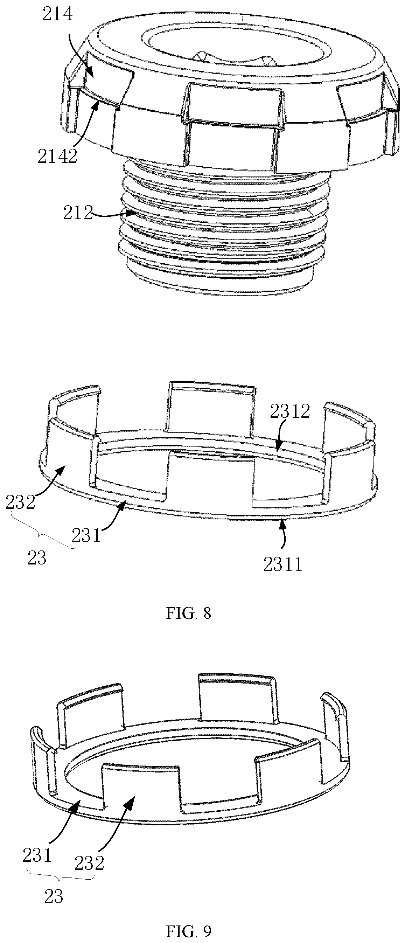

In some embodiments of the present disclosure, as shown in FIGS. 8, 9, and 10, a plurality of snap-fit structures 2142 are defined on a surface, away from the body portion 212, of the extension portion 214, the plurality of snap-fit structures 2142 being spaced apart; and the blocking member 23 comprises a connecting ring 231 and a plurality of connecting hooks 232, wherein the plurality of connecting hooks 232 are connected to the connecting ring 231 and circumferentially spaced apart along the connecting ring 231, and the plurality of connecting hooks 232 are configured to respectively snap-fit with corresponding snap-fit structures 2142.

To adapt to the shape of the connecting member 21, the blocking member 23 includes a connecting ring 231, which is configured to surround and conform to the outer side of the extension portion to meet the connection requirements with the connecting member 21 and the sealing requirements for the first side of the groove 2141.

In some possible designs, as shown in FIGS. 8 and 9, an axial length of the connecting ring 231 is less than a radial length of the connecting ring 231, wherein the radial length is a distance between an outer side wall 2311 and an inner side wall 2312 of the connecting ring 231. The connecting ring 231 is configured to block the open first side of the groove 2141. The plurality of connecting hooks 232 are perpendicularly connected to the outer side wall 2311 of the connecting ring 231 and configured to snap-fit with the plurality of snap-fit structures 2142 on the extension portion 214.

In some other possible designs, the axial length of the connecting ring 231 is greater than the radial length of the connecting ring 231. The connecting ring 231 has an upper wall and a lower wall that are opposite along the axial direction. The plurality of connecting hooks 232 are connected to the upper wall of the connecting ring 231 and configured to snap-fit with the plurality of snap-fit structures 2142 on the extension portion 214. The blocking member 23 further includes a blocking ring, which is connected to the lower wall of the connecting ring 231 and extends toward the inner side of the connecting ring 231 to block the open first side of the groove 2141.

In the electric drive housing provided by the embodiments of the present disclosure, the connecting member 21 and the blocking member 23 are detachably connected via the snap-fit structures 2142 and the connecting hooks 232, which in a first aspect limits the position of the first sealing member 22 in the groove 2141 and in a second aspect improves the waterproof and dustproof effect because of the contact between the blocking member 23 and the outer wall of the protruding portion 14 in the case that the sealing assembly 2 is assembled to the housing body 1, thereby facilitating the sealing for the operation opening 12 by the sealing assembly 2 and reducing the aging of the first sealing member 22. The snap-fit connection method has a relatively simple and quick assembly process, thereby saving time and production costs. Additionally, the snap-fit structure 2142 allows for relatively easy disassembly of the two components, making maintenance, repair, or component replacement convenient, and the disassembly is achieved without using complex tools or cumbersome operations.

In some embodiments, the snap-fit structure 2142 is a snap-fit block, snap-fit groove, or snap-fit hook. Those skilled in the art can select and adjust the type of snap-fit structure according to actual needs.

Because the seal effect is achieved only in the case that the first sealing member 22 contacts both the protruding portion 14 and the inner wall of the groove 2141, the inner diameter of the first sealing member 22 is equal to or slightly smaller than the outer diameter of the protruding portion 14. During the mounting process, in a first aspect, the first sealing member 22 is difficult to accurately hoop the protruding portion, and in a second aspect, during the first sealing member 22 moving downward along the outer wall of the protruding portion 14 under the driving of the connecting member 21, there is always an extrusion force and friction between the first sealing member 22 and the outer wall of the protruding portion 14 when the first sealing member 22 and the outer wall of the protruding portion 14 moving relative to each other prior to the connecting member 21 being completely mounted, which makes the assembly process less smooth.

To enable the sealing assembly 2 to be more smoothly assembled to the protruding portion 14, in some embodiments of the present disclosure, an inclined surface 141 is defined on a side, away from the bottom wall 111, of an outer wall of the protruding portion 14, wherein the inclined surface 141 is gradually close to an inner wall of the protruding portion 14 as extending away from the bottom wall 111, and the inner wall of the protruding portion 14 is opposite to the outer wall of the protruding portion 14.

In some embodiments, as shown in FIGS. 5 and 6, an inclined surface 141 is additionally defined on the protruding portion 14. The inclined surface 141 facilitates the mounting of the first sealing member 22 onto the protruding portion 14. Additionally, because the outer diameter of the protruding portion 14 gradually increases at the inclined surface 141, the friction resistance during the mounting is reduced, thereby enabling smoother assembly and positioning of the first sealing member 22 and enhancing the sealing efficiency. Additionally, the design of the inclined surface 141 reduces the need for lubricant. By reducing friction resistance during assembly through the inclined surface 141, the amount of lubricant required is reduced, or assembly is achieved without lubricant.

In some embodiments, those skilled in the art select and adjust the number of the operation openings 12, the wiring harness mounting structures 13, and the seal assemblies 2 according to the number of high-voltage wiring harnesses to be assembled.

In some embodiments, the number of high-voltage wiring harnesses in the electric drive assembly is two. Correspondingly, the bottom wall 111 of the accommodating cavity 11 has two wiring harness mounting structures 13, the top wall 112 of the accommodating cavity 11 is provided with two operation openings 12, and the number of seal assemblies 2 is also two, with each assembled in one of the two operation openings 12. In the case that it is necessary to mount or take down any one of the high-voltage wiring harnesses, only the corresponding sealing assembly 2 needs to be taken down. Then, the operator performs assembly or disassembly operations on the wiring harness mounting structure 13 corresponding to that high-voltage wiring harness by inserting a tool into the corresponding operation opening 12 on the top wall 112 of the accommodating cavity 11, thereby achieving fixation or disassembly of that high-voltage wiring harness, thereby simplifying the assembly process. In this embodiment, because the high-voltage wiring harnesses and the seal assemblies 2 are in one-to-one correspondence, the corresponding high-voltage wiring harness is determined by distinguishing the sealing assembly 2, thereby avoiding errors in wire connection or disconnection.

In some embodiments, the number of high-voltage wiring harnesses in the electric drive assembly is two. Correspondingly, the bottom wall 111 of the accommodating cavity 11 is provided with two wiring harness mounting structures 13; the top wall 112 of the accommodating cavity 11 is provided with only one larger-area operation opening 12, with the two wiring harness mounting structures 13 located within the orthographic projection of the operation opening 12 on the bottom wall 111; and the number of the seal assemblies 2 is also one, and the sealing assembly is mounted on the operation opening 12. In the embodiments, because there is only one operation opening 12, the machining workload for the operation opening 12 is reduced, and the assembly workload for assembling two high-voltage wiring harnesses is simultaneously reduced.

As shown in FIGS. 1 and 2, in some embodiments, a through hole 15 is defined in a side wall of the housing body 1, one end of the high-voltage wiring harness passes through the through hole 15 into the accommodating cavity 11, and is connected to the EMC component within the accommodating cavity 11. Those skilled in the art can select and adjust the number and size of the through holes 15 according to the number of high-voltage wiring harnesses to be assembled.

The present disclosure further provides a powertrain including the aforementioned housing for the powertrain. In some embodiments, the powertrain is a hybrid powertrain or an electric drive assembly.

The present disclosure further provides a vehicle including the aforementioned housing for the powertrain, or including the aforementioned powertrain.

In the vehicle provided by the embodiments of the present disclosure, an accommodating cavity 11 is defined in the housing body 1 for accommodating the EMC component, and a wiring harness mounting structure 13 is disposed on the bottom wall 111 of the accommodating cavity 11. The high-voltage wiring harness is connected to the EMC component and fixed in the accommodating cavity 11 via the wiring harness mounting structure 13. The top wall 112 of the housing body 1 is further provided with an operation opening 12, and the housing body is sealed or opened via the sealing assembly 2. In the case that the wiring harness needs to be mounted or taken down, the complete mounting or taking down process is achieved by just taking down the sealing assembly 2, fixing or taking down the high-voltage wiring harness by operating the wiring harness mounting structure 13 through the operation opening 12 on the top wall 112 of the accommodating cavity 11, and then mounting the sealing assembly 2 again. Compared to the split-type electric drive housing in the related art, the embodiments of the present disclosure simplify the assembly process of the electric drive housing, reduce the number of connecting members, and employ a simple and reliable sealing method.

In some embodiments, the vehicle provided by the embodiments of the present disclosure includes an electric drive assembly, which includes the aforementioned housing.

In the description of the present disclosure, it should be understood that the terms "center," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," "circumferential," etc., indicate orientations or position relationships based on that shown in the drawings and are used merely to facilitate the description of the present disclosure and simplify the description. They are not intended to indicate or imply that the devices or components referred to must have a specific orientation, be constructed in a specific orientation, or operate in a specific orientation. Therefore, they should not be construed as limiting the scope of the present disclosure.

Furthermore, the terms "first" and "second" are used merely for descriptive purposes and should not be interpreted as indicating or implying relative importance or the number of technical features indicated. Accordingly, features defined by "first" or 'second' explicitly or implicitly mean that there are one or more such features. In the description of the present disclosure, "a plurality of" means two or more, unless otherwise explicitly specified.

In the present disclosure, unless otherwise explicitly specified and limited, terms such as "mounted," "connected," "coupled," and "fixed" should be interpreted in a broad sense. In some embodiments, they include fixed connections, detachable connections, or forming one-piece structures; they include mechanical connections, electrical connections, or communication connections; or they include direct connections or indirect connections through an intermediate medium, or they include internal connections between two components or interactive relationships between two components. For those skilled in the art, the specific meanings of the above terms in the present disclosure are understood based on the specific circumstances.

In the present disclosure, unless otherwise explicitly specified and limited, a first feature being "on" or "under" a second feature includes direct contact between the first and second features, or indirect contact between the first and second features through an intermediate medium. Furthermore, the first feature being "above," "on top of," or "on" the second feature means that the first feature is right above or oblique above the second feature, or simply indicates that the first feature has a higher horizontal level than the second feature. The first feature being "below," "under," or "underneath" the second feature means that the first feature is right below or oblique below the second feature, or simply indicates that the first feature has a lower horizontal level than the second feature.

In the description of the specification, the terms "an embodiment," "some embodiments," "example," "specific example," or "some examples" refer to the specific features, structures, materials, or characteristics described in conjunction with such embodiments or examples being included in at least one embodiment or example of the present disclosure. In the specification, the illustrative descriptions using the above terms are not necessarily directed to the same embodiment or example. Furthermore, the specific features, structures, materials, or characteristics described can be appropriately combined in any one or more embodiments or examples. Additionally, on the premise of no contradiction, those skilled in the art can combine and integrate the different embodiments or examples described in this specification or the features of different embodiments or examples.

Although embodiments of the present disclosure have been shown and described, those skilled in the art can understand that various changes, modifications, substitutions, and variations can be made to these embodiments without departing from the concept and principle of the present disclosure. The scope of the present disclosure is defined by the claims and their equivalents.

## Claims

1. A housing for a powertrain, comprising: a housing body (1) and a sealing assembly (2);
wherein an accommodating cavity (11) is defined in the housing body (1), the accommodating cavity (11) having a top wall (112) and a bottom wall (111) that are opposite to each other, wherein an operation opening (12) is defined in the top wall (112), and a wiring harness mounting structure (13) is disposed on the bottom wall (111), the wiring harness mounting structure (13) being configured to secure a high-voltage wiring harness in the powertrain; and
the sealing assembly (2) is detachably connected to the operation opening (12) and configured to seal or open the accommodating cavity (11).

2. The housing for the powertrain according to claim 1, wherein an opening area of the operation opening (12) is smaller than an area of the top wall (112) of the accommodating cavity (11).

3. The housing for the powertrain according to claim 1, wherein an orthographic projection of the wiring harness mounting structure (13) on the bottom wall (111) is within an orthographic projection of the operation opening (12) on the bottom wall (111).

4. The housing for the powertrain according to claim 1, wherein a center of the operation opening (12) is located on a centerline of a designated surface, wherein the designated surface is a surface configured to be connected to a tool and achieve assembly and disassembly in operation surfaces of the wiring harness mounting structure (13).

5. The housing for the powertrain according to claim 1, wherein
the sealing assembly (2) comprises a connecting member (21), wherein a mounting groove (211) is defined in the connecting member (21), an opening of the mounting groove (211) facing the bottom wall (111); and
the housing body (1) comprises a protruding portion (14), wherein the protruding portion (14) is connected to a side, away from the bottom wall (111), of the top wall (112) and surrounds the operation opening (12), and the protruding portion (14) is disposed within the mounting groove (211) and hermetically connected to the mounting groove (211).

6. The housing for the powertrain according to claim 5, wherein the connecting member (21) comprises a body portion (212), a connecting portion (213), and an extension portion (214) that are sequentially connected; wherein
the body portion (212) is positioned at an inner side of the protruding portion (14) and extends into the operation opening (12), and the body portion (212) is detachably connected to the top wall (112);
the connecting portion (213) is connected to an end, away from the bottom wall (111), of the body portion (212) and rests on an end, away from the top wall (112), of the protruding portion (14); and
the extension portion (214) is connected to an end, away from the body portion (212), of the connecting portion (213) and extends toward the bottom wall (111), the extension portion (214) and the body portion (212) are spaced apart, and the body portion (212), the connecting portion (213), and the extension portion (214) collaboratively define the mounting groove (211).

7. The housing for the powertrain according to claim 6, wherein
a groove (2141) is defined in a surface, facing the body portion (212), of the extension portion (214); and
the sealing assembly (2) comprises a first sealing member (22), wherein the first sealing member (22) is received in the groove (2141) and separately abuts against a groove bottom wall (111) of the groove (2141) and an outer wall of the protruding portion (14), the groove bottom wall (111) being opposite to the outer wall of the protruding portion (14).

8. The housing for the powertrain according to claim 7, wherein the first sealing member (22) is a sealing ring, and a width of the groove (2141) is less than or equal to an outer diameter of the sealing ring.

9. The housing for the powertrain according to claim 7, wherein the groove (2141) is defined in a surface, close to the body portion (212), of the extension portion (214) and positioned in a middle region of the extension portion (214).

10. The housing for the powertrain according to claim 7, wherein the groove (2141) extends to an edge, away from the connecting portion (213), of the extension portion (214) to cause a side, away from the connecting portion (213), of the groove (2141) to open; and
the sealing assembly (2) further comprises a blocking member (23), wherein the blocking member (23) is snap-fit with the connecting member (21), and at least a portion of the blocking member (23) is disposed on a side, close to the bottom wall (111), of the extension portion (214) to close the side, away from the connecting portion (213), of the groove (2141).

11. The housing for the powertrain according to claim 10, wherein
a plurality of snap-fit structures (2142) are defined on a surface, away from the body portion (212), of the extension portion (214), the plurality of snap-fit structures (2142) being spaced apart; and
the blocking member (23) comprises a connecting ring (231) and a plurality of connecting hooks (232), wherein the plurality of connecting hooks (232) are connected to the connecting ring (231) and circumferentially spaced apart along the connecting ring (231), and the plurality of connecting hooks (232) are configured to respectively snap-fit with corresponding snap-fit structures (2142).

12. The housing for the powertrain according to claim 11, wherein an axial length of the connecting ring (231) is less than a radial length of the connecting ring (231), the connecting ring (231) is configured to block the side, away from the connecting portion (213), of the groove (2141), and the plurality of connecting hooks (232) are perpendicularly connected to an outer side wall (2311) of the connecting ring (231), the radial length is a distance between the outer side wall (2311) and an inner side wall (2312) of the connecting ring (231).

13. The housing for the powertrain according to claim 5, wherein an inclined surface (141) is defined on a side, away from the bottom wall (111), of an outer wall of the protruding portion (14), wherein the inclined surface (141) is gradually close to an inner wall of the protruding portion (14) as extending away from the bottom wall (111), and the inner wall of the protruding portion (14) is opposite to the outer wall of the protruding portion (14).

14. A powertrain, comprising: the housing for the powertrain as defined in any one of claims 1 to 13.

15. A vehicle, comprising: the housing for the powertrain as defined in any one of claims 1 to 13, or the powertrain as defined in claim 14.
